# EUROPEAN PATENT SPECIFICATION

(11) **EP 2 692 910 B1**
(45) Date of publication and mention of the grant of the patent: **10.05.2023**
(21) Application number: 12762737.0
(22) Date of filing: 23.03.2012
(51) Int. Cl.: C30B 29/12, G02B 27/28, G02F 1/09, C30B 15/00, G02B 6/27

(54) **FARADAY ROTOR, OPTICAL ISOLATOR AND OPTICAL PROCESSING EQUIPMENT**
FARADAY-ROTOR, OPTISCHER ISOLATOR UND OPTISCHE VERARBEITUNGSAUSRÜSTUNG
ROTOR DE FARADAY, ISOLATEUR OPTIQUE ET ÉQUIPEMENT DE TRAITEMENT OPTIQUE

(30) Priority: 28.03.2011 JP 2011069059
(43) Date of publication of application: 05.02.2014
(73) Proprietor: National Institute for Materials Science, Tsukuba-shi, Ibaraki 305-0047 (JP)
(72) Inventor: SHIMAMURA Kiyoshi, Tsukuba-shi Ibaraki 305-0047 (JP); GARCIA VILLORA Encarnacion Antonia, Tsukuba-shi Ibaraki 305-0047 (JP)
(74) Representative: Vossius & Partner Patentanwälte Rechtsanwälte mbB
(86) International application number: PCT/JP2012/057543
(87) International publication number: WO 2012/133200

(56) References cited:
- EP-A1- 2 485 071
- DE-A1- 19 541 852
- JP-A- 9 068 675
- JP-A- 2003 005 241
- JP-A- 2004 012 997
- JP-A- 2005 345 492
- JP-A- 2008 194 751
- C. LEYCURAS ET AL: "Magnetic susceptibility and Verdet constant in rare earth trifluorides", JOURNAL OF APPLIED PHYSICS, vol. 55, no. 6, 15 March 1984 (1984-03-15) , page 2161, XP055092790, US ISSN: 0021-8979, DOI: 10.1063/1.333596
- C.LEYCURAS ET AL.: 'Magnetic susceptibility and Verdet constant in rare earth trifluorides' JOURNAL OF APPLIED PHYSICS vol. 55, no. 6, 15 March 1984, pages 2161 - 2163, XP055092790
- M. J. Weber ET AL: "Magneto-optical properties of KTb 3 F 10 and LiTbF 4 crystals", Journal of Applied Physics, vol. 49, no. 6, 1 June 1978 (1978-06-01), pages 3464-3469, XP055593942, US ISSN: 0021-8979, DOI: 10.1063/1.325255
- J. A. Griffin ET AL: "Magnetic properties of the random Ising dipolar-coupled ferromagnet LiTbp Ho1-p F4", PHYSICAL REVIEW, B. CONDENSED MATTER., vol. 24, no. 11, 1 December 1981 (1981-12-01), pages 6516-6523, XP055712055, US ISSN: 0163-1829, DOI: 10.1103/PhysRevB.24.6516

## Description

### FIELD OF THE INVENTION

The present invention relates to a Faraday rotator, an optical isolator, and optical processing equipment.

### BACKGROUND ART

Optical processing equipment is capable of irradiating workpieces with laser light for processing, so it is now used with techniques such as metal processing, markers, photolithography, and rapid prototyping. The optical processing equipment generally includes an optical isolator.

The optical isolator (OI for short) usually includes a Faraday rotator (FR for short). The Faraday rotator is a device capable of rotating the plane of polarization of incident light by the application of a magnetic field. The optical isolator is used just only on optical processing equipment but also for optical communications.

The most general material for the Faraday rotator is a garnet type single crystal that typically includes Y₃Fe₅O₁₂ (YIG). Terbium-gallium-garnet type (TGG: Tb₃Ga₅O₁₂) single crystals go into actual use too (see Non-Patent Publication 1). However, TGG is not that large in terms of the angle of Faraday rotation (Verdet constant: V), and there is still difficulty in the growth of high-quality single crystals.

Terbium-aluminum-garnet (TAG: Tb₃Al₅O₁₂) type single crystals are also under development (Non-Patent Publication 2). Although TAG has a large angle of Faraday rotation, it is not yet in the practical use because of having much difficulty in the growth of large crystals.

Further, terbium-scandium-aluminum-garnet (TSAG: Tb₃Sc₂Al₃O₁₂) type singles crystals are also under study (Patent Publication 1). However, the TSAG single crystals, too, have difficulty in the growth of large crystals because of cracking, although they have transparency.

Against such backdrops, a single crystal comprising a terbium-aluminum-garnet type single crystal with a part of Al mainly substituted by Sc and Lu, too, is under development (Patent Publication 2). This single crystal has an angle of Faraday rotation exceeding that of the TGG single crystal. In addition, this publication shows that any transmittance decrease is held back in a short wavelength region (400 to 700 nm), going on that it is possible to shorten the wavelength of laser light that is capable of high-definition processing.

However, even the aforesaid single crystal is likely to absorb laser light in a far shorter region (of up to 400 nm); in other words, there is still a problem that when the wavelength of laser light is much shortened for ever higher-precision processing, it is impossible to exploit an optical isolator making use of this single crystal.

On the other hand, it has also been well known to use fluorides such as PrF₃ and NdF₃ for optical devices (for instance, see Patent Publications 3 and 4); however, never until now is it known to use such rare earth fluorides for Faraday rotators. The use of LiTbF4 single crystal is known for Faraday rotation (Non-patent publication 3).

### Listing of the Prior Arts

### Patent Publications

Patent Publication 1: JP(A) 2002-293693
Patent Publication 2: PCT WO2011/049102
Patent Publication 3: JP(A) 2005-119952
Patent Publication 4: JP(A) 2001-75686

### Non-Patent Publications

Non-Patent Publication 1: Journal of Crystal Growth 306 (2007) 195-199
Non-Patent Publication 2: Crystal. Res. Technol., 34 (1999) 5-6, pp. 615-619
Non-Patent Publication 3: Journal of Applied Physics, 49 (1978) 3464-3469

### SUMMARY OF THE INVENTION

The invention has for its objects to make the growth of large single crystals possible, and provide a Faraday rotator, an optical isolator and optical processing equipment, all having an enhanced transmittance for wavelengths of up to 400 nm. This object is achieved with the features of the claims.

### ADVANTAGES OF THE INVENTION

The Faraday rotator of the invention includes the fluoride represented by the general formula (1) as the main component, and the aforesaid fluoride has a higher transmittance than does TGG not only in an infrared-to-visible wavelength region but also in a wavelength region of up to 400 nm as well as a high transparency in the wavelength region of up to 400 nm, so that short wavelength lasers of up to 400 nm may be used as a light source.

For that reason, the Faraday rotator of the invention makes high-definition processing feasible when it is used as the Faraday rotator of an optical isolator in optical processing equipment and the short wavelength laser is used as the light source.

Further, the aforesaid single crystal has high stability and free of any phase transition, so much so that cracking is fully held back upon cutting of the single crystal, ending up with the growth of a large single crystal with no occurrence of the secondary phase.

The Faraday rotator of the invention may be used for high-performance optical communications parts as well.

The optical isolator of the invention includes, and is comprised of, the Faraday rotator described above, and an analyzer or a polarizer. The fluoride that forms part of this Faraday rotator has a higher transmittance than does TGG not only in an infrared-to-visible wavelength region but also in a wavelength region of up to 400 nm as well as a high transparency in the wavelength region of up to 400 nm, so much so that short wavelength lasers of up to 400 nm may be used as a light source. The use of the shorter wavelength laser makes high-definition processing feasible, ending up with improvements in the performance of the optical isolator.

Comprising the optical isolator described above and the laser light source, the optical processing equipment of the invention may exploit the optical isolator capable of using short wavelength lasers of up to 400 nm as a light source, thereby enabling high-definition processing and achieving improvements in optical processing capabilities.

### BRIEF DESCRIPTION OF THE DRAWINGS

Fig. 1 is illustrative in schematic of one example of the inventive optical processing equipment.
Fig. 2 is illustrative in schematic of one example of the inventive optical isolator.
Fig. 3 is a photograph of a CeF₃ single crystal just after grown by the Cz-technique.
Fig. 4 is a photograph of a PrF₃ single crystal grown by the melting-solidification technique.
Fig. 5 is a graphical diagram indicative of wavelength dependencies of absorption coefficients α of CeF₃, PrF₃ and TGG single crystals.
Fig. 6 is a graphical diagram indicative of wavelength dependencies of absorption coefficients α of CeF₃, PrF₃, LiTbF₄, LiDyF₄, LiHoF₄, LiErF₄ and LiYbF₄.
Fig. 7 is a graphical diagram indicative of wavelength dependencies of Verdet constants of CeF₃, PrF₃, LiTbF₄, LiDyF₄, LiHoF₄, LiErF₄, LiYbF₄ and TGG single crystals.
Fig. 8 is a graphical diagram indicative of wavelength dependencies of performance indices (V/α) of CeF₃, PrF₃ and TGG single crystals.
Fig. 9 is a graphical diagram indicative of wavelength dependencies of performance indices (V/α) of LiTbF₄, LiDyF₄, LiHoF₄, LiErF₄ and LiYbF₄.

### MODES FOR CARRYING OUT THE INVENTION

### (Embodiments of the Invention)

The Faraday rotators, optical isolators and optical processing equipment according to some embodiments of the invention will now be explained with reference to the accompanying drawings.

### (Constructions of the Faraday Rotator, Optical Isolator, and Optical Processing Equipment)

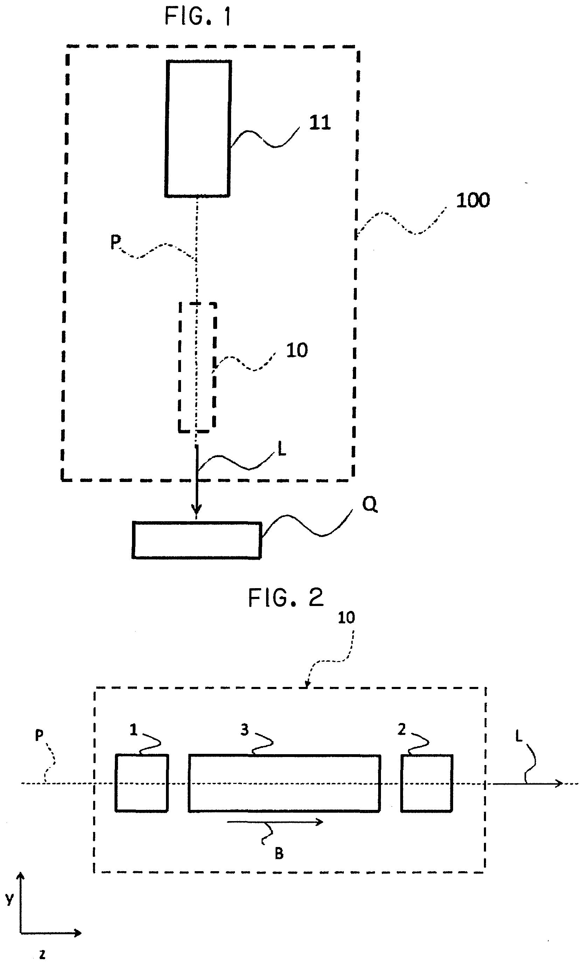

Fig. 1 is a schematic view of one example of the optical processing equipment according to one embodiment of the invention.

As depicted in Fig. 1, the optical processing equipment indicated generally by 100 includes, and is generally constructed of, a laser light source 11 and an optical isolator 10.

Light L exiting out from the laser light source 11 propagates on an optical path P, and enters and passes through the optical isolator 10, radiating out from its other end and striking upon a workpiece Q.

The optical isolator is an optical device having a function of transmitting light in one direction alone and blocking off light coming back after reflection. By having the optical isolator 10, the optical processing equipment 100 can protect the laser light source 11 from the returning light that may cause the instability of, and damage to, the laser light source 11.

Fig. 2 is a schematic view of one example of the optical isolator according to one embodiment of the invention.

As can be seen from Fig. 2, the optical isolator 10 includes, and is generally constructed of, a polarizer 1 located on its one end side, a Faraday rotator 3 and an analyzer 2 located on its other end side in this order.

The Faraday rotator 3 is in a columnar shape, in a cylindrical shape. However, the Faraday rotator 3 is not limited to any specific shape; for instance, it may take on a thin-film shape, a bulk shape, a fiber form or the like.

The polarizer 1 and the analyzer 2 are located such that their transmission axes are nonparallel with each other, for instance, at an angle of 45° between them. Note here that the polarizer may be used instead of the analyzer 2.

The Faraday rotator 3 is designed such that a magnetic field B may be applied by a magnet to it parallel with the direction of incidence of light.

By the application of the magnetic field B, the Faraday rotator 3 is operable to rotate the plane of polarization of light L passing through the polarizer 1.

The angle of Faraday rotation is here defined by the angle at which the plane of polarization is rotatable by the Faraday rotator 3, and the larger this angle, the higher of the efficiency of the Faraday rotator grows. And the angle of Faraday rotation is correlated with the Verdet constant by a certain relation formula.

While the embodiment here exemplifies one example of the inventive optical isolator, it is to be understood that the invention is not limited to it.

### (Faraday Rotator)

The Faraday rotator 3 according to the invention contains as its main component or ingredient the fluoride represented by the following formula (1) or (2).

RE1F₃₋ₓ ··· (1)

LiRE2F₄₋ₓ ··· (2)

where x=0 and RE1 is at least one element selected from the group of rare earth elements, and RE2 is at least one element selected from the group consisting of Dy, Ho, Er and Yb.

Just one requirement for the Faraday rotator 3 according to a specific embodiment of the invention is that it contains as its main component the fluoride represented by the general formula (1) or (2); the Faraday rotator 3 may contain other components as subordinates.

By "containing the fluoride as the main component" here, it is meant that the fluoride represented by the general formula (1) or (2) is contained in the material that makes up the Faraday rotator 3 according to a specific embodiment of the invention in an amount of at least 50 wt%.

The content of the fluoride represented by the general formula (1) or (2) should be preferably at least 80 wt%, more preferably at least 90 wt%, and even more preferably 99 wt% so as to make transparency much higher.

The other components may include a metal halogenide represented by a fluoride of a metal selected from the group consisting of an alkali metal, an alkaline earth metal and a rare earth metal, and an oxide of a metal selected from the group consisting of an alkali metal, an alkaline earth metal and a rare earth metal. These other components may be contained in the form of dopants added during single crystal preparation, or the like.

The fluoride represented by the general formula (1) or (2) where x=0 is much more reduced in terms of in-crystal defects or the like. For this reason, when this fluoride is used to set up the Faraday rotator 3, it is then possible to obtain satisfactory optical quality, maintain the reproducibility of the angle of Faraday rotation (Verdet constant), and minimize variations in the angle of Faraday rotation (Verdet constant).

When x in the general formula (1) or (2) is more than 0.1, it is then impossible to obtain optical quality enough to make sure any Faraday rotator, and take hold of sufficient transparency in the wavelength region of up to 400 nm. In addition, upon cutting of the single crystal, there is a risk of giving rise to cracks or the secondary phase in it.

The Faraday rotator 3 according to a specific embodiment of the invention should preferably comprise the single crystal of the aforesaid fluoride.

The aforesaid single crystal has transparency in an infrared-to-visible light wavelength region, and even in a wavelength region of up to 400 nm among others, so that when it is used to set up the Faraday rotator 3, a 400-nm or shorter wavelength laser may be used, and when that Faraday rotator 3 is used as a Faraday rotator in the optical isolator of the optical processing equipment, it is possible to implement high-definition processing.

To add to this, the aforesaid single crystal, because of having high stability and being free of any phase transition, is well reduced in terms of cracks occurring upon cutting and free of the secondary phase, resulting in larger size.

The Faraday rotator 3 according to a specific embodiment of the invention may be made up of a polycrystal or amorphous body provided, however, that they have properties similar to those of the single crystal of the fluoride represented by the general formula (1) or (2).

More specifically, use may be made of ceramics (including transparent ceramics), and glasses.

Note here that the transparent ceramics has a transmittance of 80% or higher in the infrared-to-visible light wavelength region, and a transmittance of 80% or higher even in the wavelength region of up to 400 nm among others, and may be easily molded by a sintering process under pressurization.

By the "properties similar to those of the single crystal of the fluoride represented by the general formula (1) or (2)", it is meant that the transparency in the infrared-to-visible light wavelength region, the transparency in the wavelength region of up to 400 nm among others, and the reproducibility of the angle of Faraday rotation (Verdet constant) are at least equal to those of the single crystal of the fluoride represented by the general formula (1) or (2).

Accordingly, even when the Faraday rotator 3 is made up of the polycrystal or amorphous body, the 400-nm or shorter wavelength laser may be used, and when it is used as a Faraday rotator in the optical isolator of the optical processing equipment, it makes high-definition processing feasible.

The fluoride represented by the general formula (1) should preferably be any material of CeF₃, PrF₃, NdF₃, TbF₃, DyF₃, and HoF₃.

The Faraday rotator 3 set up using any material of CeF₃, PrF₃, NdF₃, TbF₃, DyF₃, and HoF₃ has high transparency in the infrared-to-visible light wavelength region, and has high transparency and a large angle of Faraday rotation even in the wavelength region of up to 400 nm among others, making it possible to use a 400-nm or shorter wavelength laser as the light source, so ensuring a high performance index (V/α).

Especially when the single crystal of the material of any one of CeF₃, PrF₃, NdF₃, TbF₃, DyF₃, and HoF₃ is used as the material that makes up the Faraday rotator 3, it is possible to make transparency in the infrared-to-visible light wavelength region much higher, combine much higher transparency even in the wavelength region of up to 400 nm in particular with a large angle of Faraday rotation, and minimize the occurrence of cracks or the secondary phase upon cutting of the single crystal.

The fluoride represented by the general formula (2) should more preferably be any material of LiDyF₄, LiHoF₄, LiErF₄ or LiYbF₄.

The Faraday rotator 3 constructed of any material of LiDyF₄, LiHoF₄, LiErF₄ or LiYbF₄ has high transparency in the infrared-to-visible light wavelength region, and has high transparency and a large angle of Faraday rotation even in the wavelength region of up to 400 nm among others, so that a 400-nm or shorter wavelength laser may be used as the light source, making sure a high performance index (V/α).

Especially when the single crystal of any material of LiDyF₄, LiHoF₄, LiErF₄ or LiYbF₄ is used as the material that makes up the Faraday rotator 3, it is possible to make transparency in the infrared-to-visible light wavelength region much higher, combine much higher transparency even in the wavelength region of up to 400 nm among others with a large angle of Faraday rotation, and minimize the occurrence of cracks or the secondary phase upon cutting of the single crystal.

### (How to Fabricate the Faraday Rotator)

The single crystal of the fluoride represented by the general formula (1) or (2) may be grown by the Czochralski technique (the Cz-technique for short) typically in the following manner.

First of all, given materials weighed in a given molar ratio are mixed together in a crucible, and a chamber with the crucible placed in it was evacuated down to a vacuum by means of a vacuum pump. Then, the chamber is replaced by a CF₄ (>99.99%) atmosphere in which the mixture in the crucible is slowly molten and slowly cooled down to form the first single crystal in a substantially disk form.

Then, a c-axis oriented seed crystal of rod shape is cut out from the first single crystal.

Then, given materials weighed in a given molar ratio in the same way as described above are mixed together in a crucible, followed by the location of the crucible in a chamber. Thereafter, the chamber is brought up to a high vacuum by means of a vacuum pump for efficient removal of oxygen from within the chamber, and then replaced by a CF₄ (>99.99%) atmosphere.

Then, the crucible is heated by a high-frequency coil connected to a high-frequency oscillator (30 kW) to melt the mixture slowly in the crucible.

Then, the aforesaid rod-form seed crystal is dipped in the melt in the crucible from its one end side, and with the seed crystal rotating about the center axis of the rod, it is pulled up toward the other end side of the rod for growth of a single crystal on the melt side of the rod-form seed crystal. For instance, the rotation and pulling rates are set at 1 to 50 rpm and 0.1 to 10 mm/h, respectively.

Through a series of such operations, there can be a single crystal formed around the rod from its one end side.

Then, a crystal is cut out from the aforesaid single crystal in a given form, for instance, in a substantially cylindrical form with the c-axis oriented in the longitudinal direction. Thus, when this single crystal is configured as an optical isolator, its c-axis direction aligns parallel with the direction of the magnetic field B.

Then, given surfaces of the substantially cylindrical single crystal (for instance, the entrance and exit surfaces of a Faraday rotator) are polished off by means of a given polishing process.

Then, antireflection films are formed on the given surfaces.

Through a series of the steps as described above, it is possible to fabricate the Faraday rotator 3 according to a specific embodiment of the invention comprising the single crystal of the fluoride represented by the general formula (1) or (2).

The Faraday rotator 3 according to a specific embodiment of the invention is made up of the single crystal represented by the general formula (1) or (2), and this single crystal has a transmittance higher than that of TGG just only in the infrared-to-visible light wavelength region but has also high transmittance and high transparency in the 400-nm or shorter wavelength region, so much so that a 400-nm or shorter wavelength laser can be used as the light source.

For this reason, when that Faraday rotator 3 is used as a Faraday rotator in the optical isolator of the optical processing equipment and a short wavelength laser is used as the light source, it is then possible to implement high-definition processing.

In addition, the aforesaid single crystal has high stability and is free of any phase transition, so much so that cracking is fully held back upon cutting of the single crystal, resulting in larger size with no occurrence of the secondary phase.

The inventive single crystal may be used for optical communications parts as well.

The single crystal comprising any material of CeF₃, PrF₃, NdF₃, TbF₃, DyF₃ or HoF₃ or the single crystal comprising any material of LiDyF₄, LiHoF₄, LiErF₄ or LiYbF₄ allows for crystal growth at a temperature lower than could be possible with the TGG single crystal, and its fabrication cost may be curtailed as well.

To add to this, the high transmittance and high Verdet constant at up to 400 nm also contribute to making single crystal size larger. This in turn makes it easy to achieve Faraday rotators having improved transmittance at up to 400 nm, resulting in some considerable improvements in the performance of optical isolators.

The aforesaid single crystal may also be fabricated by the Bridgeman technique.

Crystal growth by the Bridgeman technique may be implemented typically as follows.

Given materials weighed at a given molar ratio are stirred in a crucible that is then placed in a chamber.

Thereafter, the chamber is evacuated to a high vacuum by a vacuum pump for efficient water content removal, and while that high vacuum is maintained, electricity is supplied to a resistance heating type heat source located around the crucible to melt the materials in the crucible. Note here that the heat source has a temperature gradient such that its upper portion is at a temperature higher than the melting points of the materials and its lower portion is at a temperature lower than the melting points of the materials.

After the materials are molten, the crucible is moved from the upper portion at a temperature higher than the melting points down to the lower portion at a temperature lower than the melting points, and the melt is single crystallized upon coming down to where there is a temperature equal to or lower than the melting points. If this is continuously implemented, single crystal may then be continuously grown.

Such processes as the pulling-up technique or the Bridgeman technique are referred to by way of example but not by way of limitation.

Reliance may also be on other fabrication techniques, for instance, the melting-solidification technique, the floating zone technique (FZ for short), and the micropulling down technique (the µ-PD process for short): the invention is not limited to any specific technique whatsoever.

The Faraday rotator 3 according to a specific embodiment of the invention contains as the main component the fluoride represented by the general formula (1) or (2) in an amount of 50 wt% or greater, and makes sure higher transparency in the 400-nm or shorter wavelength region, so that a 400-nm or shorter wavelength laser can be used as a light source. For this reason, when it is used as a Faraday rotator in the optical isolator of the optical processing equipment and the shorter wavelength laser is used as the light source, it makes sure high-definition processing. The Faraday rotator 3 may also be used as high-performance optical communications parts.

The Faraday rotator 3 according to a specific embodiment of the invention comprises a polycrystal of the aforesaid fluoride, and makes sure higher transparency in the 400-nm or shorter wavelength region, so that a 400-nm or shorter wavelength laser can be used as a light source. For this reason, when it is used as a Faraday rotator in the optical isolator of an optical processing equipment and the shorter wavelength laser is used as the light source, it makes sure high-definition processing. The Faraday rotator 3 may also be used as high-performance optical communications parts.

The Faraday rotator 3 according to a specific embodiment of the invention comprises an amorphous body of the aforesaid fluoride, and makes sure higher transparency in the 400-nm or shorter wavelength region, so that a 400-nm or shorter wavelength laser can be used as a light source. For this reason, when it is used as a Faraday rotator in the optical isolator of the optical processing equipment and the shorter wavelength laser is used as the light source, it makes sure high-definition processing. The Faraday rotator 3 may also be used as high-performance optical communications parts.

The optical isolator 10 according to a specific embodiment of the invention includes, and is constructed of, the Faraday rotator 3, the analyzer 2, and the polarizer 1, and is capable of using a 400-nm or shorter wavelength laser and implementing high-definition processing, resulting in some considerable performance improvements.

The optical processing equipment 100 according to a specific embodiment of the invention includes, and is constructed of, the optical isolator 10 and a laser light source 11, and is capable of using a 400-nm or shorter wavelength laser, making sure high-definition processing.

The Faraday rotator, optical isolator and optical processing equipment according to specific embodiments of the invention are disclosed herein by way of example but not by way of limitation; they may be variously modified within the technical concept of the invention. Examples of specific embodiments of the invention will be given below by way of illustration but not by way of limitation.

### EXAMPLES

### (Example 1)

### [Fabrication of the Single Crystal and Faraday Rotator]

A CeF₃ single crystal (of Example 1) was prepared by the Cz-technique including the following steps.

### [Preparation of the Seed Crystal]

First of all, a given amount of a given commercial material (CeF₃ having purities>99.99%) was filled in a Pt-crucible.

Then, the Pt-crucible was located in a chamber from which oxygen was efficiently removed by a vacuum pump, allowing a CF₄ (>99.99%) atmosphere to prevail in that chamber.

Then, the Pt-crucible was heated by a high-frequency coil located around it and connected to a high-frequency oscillator (30 kW) up to a temperature higher than the melting point of a CeF₃ single crystal, thereby slowly melting the material in the crucible.

Then, the mixture material was slowly cooled down to form a single crystal of disk shape.

Then, a c-axis oriented seed crystal of rod shape was cut out from the aforesaid single crystal.

### [Growth of the Single Crystal]

A Pt-crucible was located in a chamber from which oxygen was efficiently removed by a vacuum pump, allowing a CF₄ (>99.99%) atmosphere to prevail in that chamber.

Then, the Pt-crucible was heated by a high-frequency coil located around it and connected to a high-frequency oscillator (30 kW) up to a temperature higher than the melting point of a CeF₃ single crystal, thereby slowly melting the material in the crucible.

Then, the seed crystal of rod shape was dipped in the melt in the Pt-crucible, after which it was pulled up while rotated thereby growing a single crystal on the melt side of the seed crystal of rod shape. The rotating and pulling-up rates were 15 rpm and 2 mm/h, respectively.

The grown single crystal had a length set at 100 mm.

Through the aforesaid steps, a CeF₃ single crystal (of Example 1) was prepared.

### [Preparation of the Faraday Rotator]

A c-axis oriented, cuboidal single crystal was cut out from the aforesaid single crystal. Crystal length was set at 10 mm for a comparison with a TGG reference crystal having the same length.

Then, two surfaces vertical to the optical axis (c-axis) were polished off, after which antireflection films were formed on them.

Through the aforesaid steps, a Faraday rotator (of Example 1) comprising the CeF₃ single crystal was prepared.

### (Example 2)

The melt-solidification technique was applied to prepare a PrF₃ single crystal (of Example 2) through the following steps.

First of all, a given commercial material (PrF₃ having purities>99.99%) weighed in a given amount was filled up in a Pt-crucible.

The Pt-crucible was located in a chamber from which oxygen was efficiency removed by a vacuum pump, allowing a CF₄ (>99.99%) atmosphere to prevail in that chamber.

Then, the Pt-crucible was heated by a high-frequency coil located around it and connected to a high-frequency oscillator (30 kW) up to a temperature higher than the melting point of the PrF₃ single crystal, thereby slowly melting the material in the crucible.

Then, the material in the crucible was slowly cooled down to form a single crystal of disk shape.

Then, a c-axis oriented single crystal of rod shape was cut out from the aforesaid single crystal.

As in Example 1, the Faraday rotator (of Example 2) comprising the PrF₃ single crystal was prepared.

### (Example 3, not part of this disclosure)

The Cz-technique was applied to prepare a LiTbF₄ single crystal (of Example 3) through the following steps.

First of all, TbF₃ (having purities>99.99%) and LiF (having purities >99.99%) weighed in given amounts were mixed together and filled up in a Pt-crucible. With a binary equilibrium state diagram in mind, mixing was implemented such that the RE concentration of TbF₃ of 37 mol% was obtained in the melt.

The Pt-crucible was located in a chamber from which oxygen was efficiently removed by a vacuum pump, allowing a CF₄ (>99.99%) atmosphere to prevail in that chamber.

Then, an a-axis oriented LiYF₄ seed crystal of rod shape was dipped in the melt in the Pt-crucible, after which it was pulled up while rotated, thereby growing a single crystal on the melt side of the seed crystal of rod shape. The rotating and pulling-up rates were 10 rpm and 1 mm/h, respectively.

Then, a c-axis oriented single crystal of rod shape (10 mm in length) was cut out from the aforesaid single crystal to prepare the Faraday rotator (of Example 3) comprising the aforesaid LiTbF₄ single crystal.

### (Example 4)

Example 3 was repeated except that DyF₃ (having purities>99.99%) and LiF were mixed together such that the RE concentration of DyF₃ of 37.5 mol% was obtained in the melt to prepare a LiDyF₄ single crystal (of Example 4).

Then, a Faraday rotator (of Example 4) comprising the LiDyF₄ single crystal was prepared as in Example 3.

### (Example 5)

Example 3 was repeated except that HoF₃ (having purities>99.99%) and LiF were mixed together such that the RE concentration of HoF₃ of 36 mol% was obtained in the melt to prepare a LiHoF₄ single crystal (of Example 5) .

Then, a Faraday rotator (of Example 5) comprising the LiHoF₄ single crystal was prepared as in Example 3.

### (Example 6)

Example 3 was repeated except that ErF₃ (having purities>99.99%) and LiF were mixed together such that the RE concentration of ErF₃ of 46 mol% was obtained in the melt to prepare a LiErF₄ single crystal (of Example 6) .

Then, a Faraday rotator (of Example 6) comprising the LiErF₄ single crystal was prepared as in Example 3.

### (Example 7)

Example 3 was repeated except that YbF₃ (having purities>99.99%) and LiF were mixed together such that 46 mol% of YbF₃ were obtained in the melt to prepare a LiYbF₄ single crystal (of Example 7).

Then, a Faraday rotator (of Example 7) comprising the LiYbF₄ single crystal was prepared as in Example 3.

### (Comparative Example 1)

The Cz-technique was used to prepare a TGG single crystal (of Comparative Example 1) under the same crystal growth conditions as in Example 1 with the exception that a given commercial material was used as the starting material, an Ir-crucible was used as the crucible, and the starting material was molten at a temperature higher than the melting point of the TGG single crystal (Tb₃Ga₅O₁₂) of 1,825°C after 2% of oxygen gas (>99.99%) were mixed with Ar gas (>99.99%) into an atmosphere without recourse to any vacuum.

A Faraday rotator (of Comparative Example 1) comprising the TGG single crystal was prepared as in Example 1.

### [Measurement of the Properties of the Single Crystals]

The following properties of the single crystals as prepared above were measured at room temperature. Note here that the magneto-optical properties were measured along the optical axis, viz., the c-axis.

Jasco V570 Spectrophotometer was used to measure transmission and reflection spectra from which the absorption coefficients α were figured out by calculation.

Then, two Glan-Taylor polarizers, a magnet, a Xe lamp and a spectrometer were used to measure the angles of Faraday rotation (the FR angle for short) of the Faraday rotators.

### [Results of Measurement of the CeF₃ Single Crystal (Ex. 1) and the PrF₃ Single Crystal (Ex. 2), and Discussions]

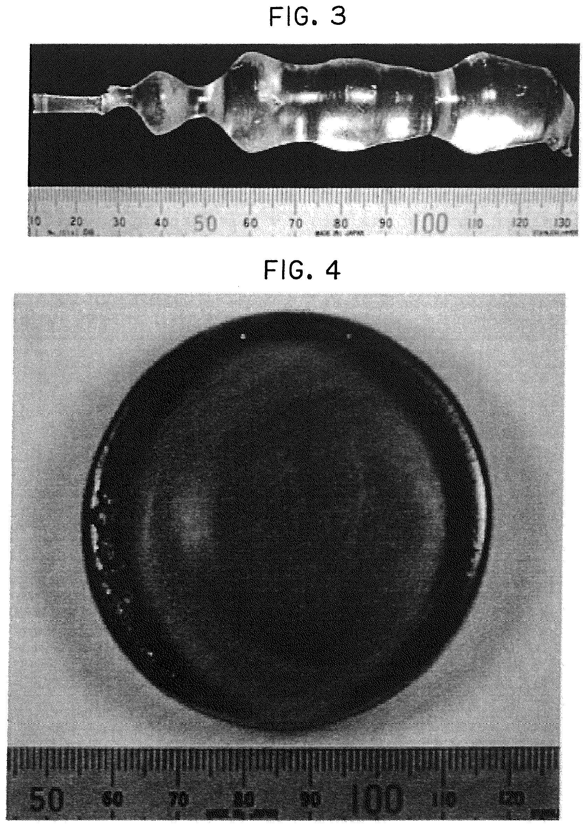

Fig. 3 is a photograph of the CeF₃ single crystal just after growth by the Cz-technique, and Fig. 4 is a photograph of the PrF₃ single crystal grown by the melt/solidification technique.

Both samples were free from twin crystals and distortion, and had high optical properties.

Then, transmittance and reflectivity were used to figure out absorption coefficients.

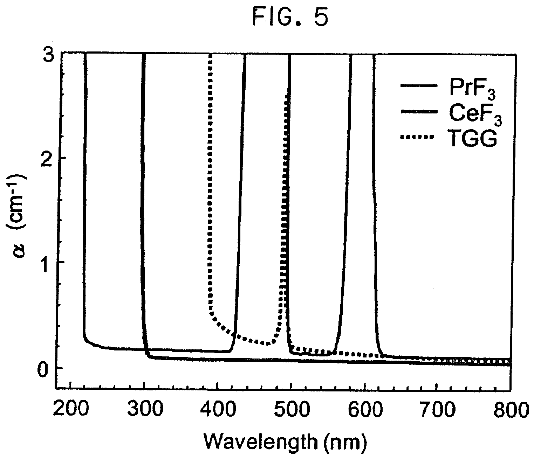

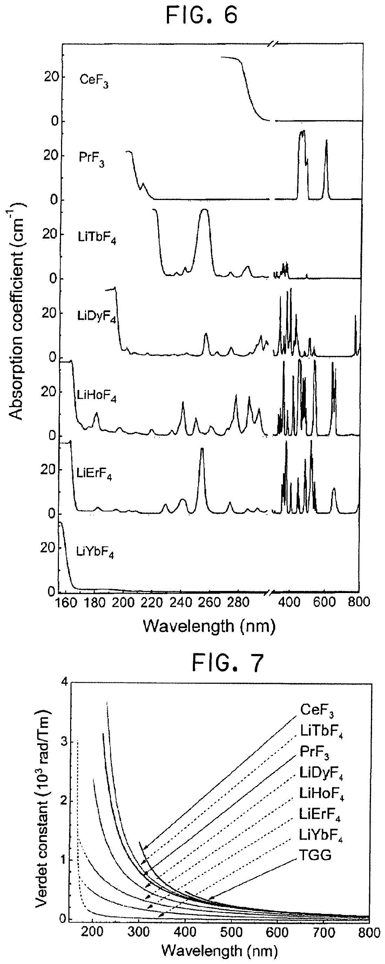

Figs. 5 and 6 are graphical diagrams indicative of the wavelength dependencies of the absorption coefficients α of CeF₃, PrF₃, LiTbF₄, LiDyF₄, LiHoF₄, LiErF₄, LiYbF₄ and TGG single crystals.

Apart from one peak in the range of 480 to 500 nm, the absorption coefficient of TGG increases in the range higher than 400 nm up to 800 nm as the wavelength becomes short, and increases sharply on a wavelength shorter than that, as can be seen from Fig. 5.

The CeF₃ single crystal has an absorption coefficient α of substantially zero in the region higher than 306 nm up to 800 nm.

Apart from two peaks in the ranges of 426 to 496 nm and 564 to 618 nm, the PrF₃ single crystal has an absorption coefficient α of substantially zero in the region greater than 220 nm up to 800 nm. Here absorption in a range of 220 nm or lower is corresponding to a transition from a ground state ³H₄ to an excitation state ¹S₀, and two peaks in the 426 to 496 nm and 564 to 618 nm regions are corresponding to a transition from the ground state ³H₄ to an excitation state ³P_{J} and a transition from the ground state ³H₄ to an excitation state ¹D₂, respectively.

It follows that in the visible or shorter light wavelength region in general, and the wavelength region of up to 400 nm in particular, the TGG single crystal has a sharply increasing absorption, so much so that when it is used as a Faraday rotator, light in the visible or shorter light region in general, and light in the region of up to 400 nm in particular cannot be used as light from a light source.

On the other hand, the CeF₃ single crystal has an absorption coefficient α of substantially zero in the region from greater than 306 nm up to the visible light in general, and in the region of up to 400 nm in particular, and the PrF₃ single crystal has an absorption coefficient α of substantially zero in the region from greater than 220 nm up to the visible light in general, and in the region of up to 400 nm in particular. When these single crystals are used as Faraday rotators, therefore, light in the region of visible light or shorter in general, and light in the region of up to 400 nm in particular may be used as light from the light source. Taking into account applications to a Faraday rotator using a laser in the region of visible light or shorter in general, and in the region of up to 400 nm in particular, the CeF₃ and PrF₃ single crystals would be superior to the TGG single crystal.

It is here to be noted that the CeF₃ single crystal has a sharply increasing absorption in the region of 306 nm or shorter, so much so that when it is used as a Faraday rotator, light in the region of 306 nm or shorter cannot be used as light from the light source.

When the PrF₃ single crystal is used as a Faraday rotator, on the other hand, light in the region of 306 nm or shorter may be used as light from the light source. Taking into account applications to a Faraday rotator using a laser of 306 nm or shorter, the PrF₃ single crystal would be superior to the CeF₃ single crystal.

As can be seen from Fig. 6, LiTbF₄, LiDyF₄, LiHoF₄, LiErF₄ and LiYbF₄ have some absorption peaks (from 4F-F4 transition), but the absorption coefficient α is substantially zero anywhere else. When these single crystals are used as Faraday rotators, therefore, light in the region of visible light or shorter in general, and light in the region of up to 400 nm in particular may be used as light from the light source. Note here that it is desired to selectively use a single crystal having an absorption coefficient α of zero for the wavelength of the light used.

Fig. 7 is a graphical diagram indicative of the wavelength dependency of Verdet constant of each of CeF₃, PrF₃, LiTbF₄, LiDyF₄, LiHoF₄, LiErF₄, LiYbF₄ and TGG single crystals. The Verdet constants here were measured in available ranges, i.e., at greater than the wavelength where the absorption coefficient α increases sharply.

These single crystals each increased sharply in the Verdet constant as the wavelength became shorter.

Given the same wavelength in the region of 600 nm or greater, the Verdet constants of PrF₃, CeF₃ and LiTbF₄ single crystals were much the same as that of the reference TGG single crystal, but the Verdet constants of LiDyF₄, LiHoF₄, LiErF₄ and LiYbF₄ single crystals were a bit smaller.

Also given the same wavelength in the region of 400 nm to less than 600 nm, the Verdet constant was at a minimum in the LiYbF₄ single crystal, growing larger in order of LiErF₄, LiHoF₄, LiDyF₄, PrF₃, LiTbF₄ and CeF₃, and reaching a maximum in the TGG single crystal.

In the region of 300 to 400 nm, the TGG single crystal did not work, and other single crystals had an increasing Verdet constant in the aforesaid order, with the CeF₃ single crystal having the greatest Verdet constant. LiTbF₄ and PrF₃ have similar Verdet constants, but PrF₃ has a merit of being higher in transparency in the narrow region of 220 to 300 nm. LiDyF₄ shows a high Verdet constant in a narrow region of 200 to 220 nm. In a region of up to 200 nm there are only three single crystals: LiHoF₄, LiErF₄ and LiYbF₄. The former two single crystals have relatively high Verdet constants, and show a 4f-4f absorption line as well. By contrast, LiYbF₄ remains transparent in a wide range of up to 170 nm, but its Verdet constant is relatively low. That Verdet constant is expected to increase sharply toward the absorption end.

Then, the absorption coefficients (Figs. 5 and 6) were correlated with the Verdet constants (Fig. 7) to calculate the performance index (V/α) of each of the CeF₃, PrF₃, LiTbF₄, LiDyF₄, LiHoF₄, LiErF₄ and LiYbF₄ single crystals.

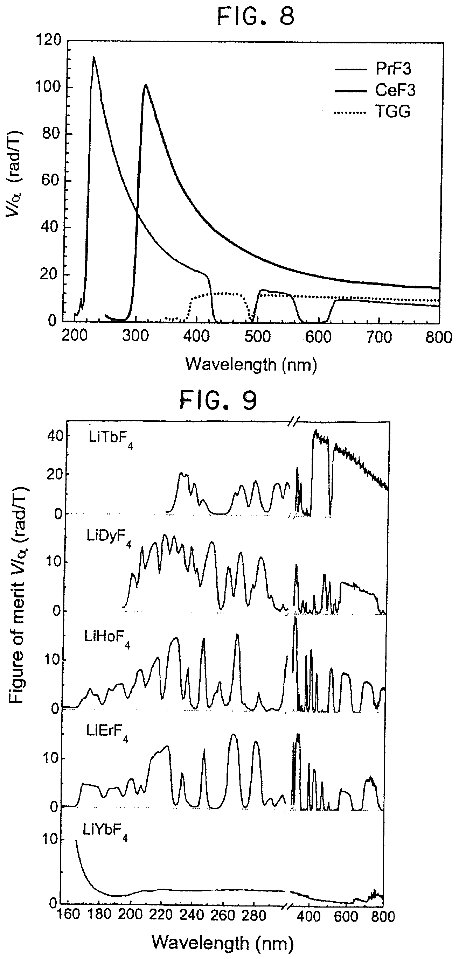

Fig. 8 is a graphic diagram indicative of the wavelength dependencies of the performance indices (V/α) of the CeF₃, PrF₃ and TGG single crystals.

The performance indices (V/α) of the CeF₃ and PrF₃ single crystals were by far greater than that of the TGG single crystal. In particular, the CeF₃ single crystal showed a performance index higher than those of both the TGG and PrF₃ single crystals in a region greater than approximately 300 nm as well as in the whole wavelength region shown in Fig. 8.

Worthy of special note is that of three such single crystals, there is only the CeF₃ single crystal material available near 490 nm. At this wavelength, other materials decrease considerably in terms of transparency.

Between the visible wavelength and approximately 300 nm, the performance index of CeF₃ increased drastically, reaching the order of 100 rad/T on approximately 300 nm.

It is also found that of three single crystals, two but the PrF₃ single crystal cannot be used as a Faraday rotator in a wavelength region of up to approximately 300 nm.

In a wavelength region from 300 nm down to 224 nm, the performance index of the PrF₃ single crystal increases drastically, with its peak value surpassing even that of the CeF₃ single crystal.

Fig. 9 is a graphical diagram indicative of the wavelength dependencies of the performance indices (V/α) of LiTbF₄, LiDyF₄, LiHoF₄, LiErF₄ and LiYbF₄.

LiTbF₄ may be used as a Faraday rotator in a wavelength region of 220 nm to 800 nm inclusive.

On up to 220 nm wavelength, LiDyF₄, LiHoF₄ and LiErF₄ may more likely be used as a Faraday rotator. There is 4f-4f absorption line, so which crystal is to be selected depends of the associated wavelength. The transmittance of LiDyF₄ decreases from 200 nm, but two other crystals remain transparent up to about 170 nm. LiYbF₄, because of having none of 4f-4f absorption line, shows the highest transparency in a region of 170 to 800 nm, but its performance index is limited by a low Verdet constant. Consequently, the effect of that single crystal as a Faraday rotator is noticeable on only an extremely short wavelength near its absorption end. Applicability to the Industry

The inventive Faraday rotator, optical isolator and optical processing equipment are higher in transparency and larger in Verdet constant and performance index than TGG in the visible wavelength region in general, and on wavelengths of up to 400 nm in particular, and they are made up of a material capable of growth of large single crystals. Consequently, they may be used in combination with lasers in the visible wavelength region in general, and on wavelengths of up to 400 nm in particular, making sure high-definition processing and having applicability to the optical processing or like industries.

1: Polarizer
2: Analyzer
3: Faraday Rotator
10: Isolator
11: Laser Light Source
100: Optical Processing Equipment
B: Flux Density (Magnetic Field)
L: Light
P: Optical Path
Q: Workpiece

## Claims

1. An optical processing equipment, comprising an optical isolator that comprises a Faraday rotator and an analyzer or a polarizer, and a laser light source, **characterized in that** the laser light source has a wavelength region of up to 400 nm, and the Faraday rotator contains as a main component a single crystal of a fluoride represented by the following general formula (1) or (2) :
RE1F₃₋ₓ ··· (1)
LiRE2F₄₋ₓ ··· (2)
where x=0, and RE1 is at least one element selected from the group of rare earth elements, and RE2 is at least one element selected from the group consisting of Dy, Ho, Er, and Yb, wherein the single crystal is a cylindrical form with a c-axis oriented in the longitudinal direction, and the c-axis of the single crystal is in alignment with a direction of incidence of the laser light on the Faraday rotator.

2. The optical processing equipment as recited in claim 1, **characterized in that** the c-axis of the single crystal is in alignment with the direction of a magnetic field applied to said Faraday rotator.

3. The optical processing equipment as recited in claim 1, **characterized in that** said fluoride has a content of at least 50 wt%.

4. The optical processing equipment as recited in claim 1, **characterized in that** RE1 in the fluoride represented by said general formula (1) is at least one element selected from the group consisting of Ce, Pr, Nd, Tb, Dy, and Ho.

5. The optical processing equipment as recited in claim 4, **characterized in that** said fluoride is any material of CeF₃, PrF₃, NdF₃, TbF₃, DyF₃, or HoF₃.

6. The optical processing equipment as recited in claim 1, **characterized in that** said fluoride represented by said general formula (2) is any material of LiDyF₄, LiHoF₄, LiErF₄, or LiYbF₄.

## Patentansprüche

1. Optische Verarbeitungsausrüstung, die einen optischen Isolator mit einem Faraday-Rotator und einem Analysator oder einem Polarisator sowie eine Laserlichtquelle aufweist,
**dadurch gekennzeichnet, dass** die Laserlichtquelle einen Wellenlängenbereich bis 400 nm hat und der Faraday-Rotator als Hauptkomponente einen Einkristall aus einem Fluorid enthält, das durch die folgende allgemeine Formel (1) oder (2) dargestellt ist:
RE1F₃₋ₓ ... (1)
LiRE2F₄₋ₓ ... (2)
wobei x = 0 ist und RE1 mindestens ein Element ist, das aus der Gruppe von Seltenerdmetallen ausgewählt ist, und RE2 mindestens ein Element ist, das aus der Gruppe ausgewählt ist, die aus Dy, Ho, Er und Yb besteht, wobei der Einkristall eine Zylinderform mit einer in Längsrichtung orientierten c-Achse hat und die c-Achse des Einkristalls zu einer Einfallsrichtung des Laserlichts auf den Faraday-Rotator ausgerichtet ist.

2. Optische Verarbeitungsausrüstung nach Anspruch 1, **dadurch gekennzeichnet, dass** die c-Achse des Einkristalls zur Richtung eines Magnetfelds ausgerichtet ist, das am Faraday-Rotator angelegt ist.

3. Optische Verarbeitungsausrüstung nach Anspruch 1, **dadurch gekennzeichnet, dass** das Fluorid einen Gehalt von mindestens 50 Gew.-% hat.

4. Optische Verarbeitungsausrüstung nach Anspruch 1, **dadurch gekennzeichnet, dass** RE1 in dem durch die allgemeine Formel (1) dargestellten Fluorid mindestens ein Element ist, das aus der Gruppe ausgewählt ist, die aus Ce, Pr, Nd, Tb, Dy und Ho besteht.

5. Optische Verarbeitungsausrüstung nach Anspruch 4, **dadurch gekennzeichnet, dass** das Fluorid ein Material aus CeF₃, PrF₃, NdF₃, TbF₃, DyF₃ oder HoF₃ ist.

6. Optische Verarbeitungsausrüstung nach Anspruch 1, **dadurch gekennzeichnet, dass** das durch die allgemeine Formel (2) dargestellte Fluorid ein Material aus LiDyF₄, LiHoF₄, LiErF₄ oder LiYbF₄ ist.

## Revendications

1. Equipement de traitement optique, comprenant un isolateur optique qui comprend un rotateur de Faraday et un analyseur ou un polarisateur, et une source de lumière laser, **caractérisé en ce que** la source de lumière laser présente une région de longueur d'onde jusqu'à 400 nm, et le rotateur de Faraday contient comme un constituant principal un monocristal d'un fluorure représenté par la formule générale (1) ou (2) suivante :
RE1F₃₋ₓ ... (1)
LiRE2F₄₋ₓ ... (2)
où x=0, et
RE1 est au moins un élément choisi dans le groupe d'éléments de terres rares, et RE2 est au moins un élément choisi dans le groupe consistant en Dy, Ho, Er, et Yb, dans lequel le monocristal est une forme cylindrique avec un axe-c orienté dans la direction longitudinale, et l'axe-c du monocristal est en alignement avec une direction d'incidence de la lumière laser sur le rotateur de Faraday.

2. Equipement de traitement optique selon la revendication 1, **caractérisé en ce que** l'axe-c du monocristal est en alignement avec la direction d'un champ magnétique appliqué audit rotateur de Faraday.

3. Equipement de traitement optique selon la revendication 1, **caractérisé en ce que** ledit fluorure présente une teneur d'au moins 50 % en masse.

4. Equipement de traitement optique selon la revendication 1, **caractérisé en ce que** RE1 dans le fluorure représenté par ladite formule générale (1) est au moins un élément choisi dans le groupe consistant en Ce, Pr, Nd, Tb, Dy, et Ho.

5. Equipement de traitement optique selon la revendication 4, **caractérisé en ce que** ledit fluorure est tout matériau de CeF₃, PrF₃, NdF₃, TbF₃, DyF₃, ou HoF₃.

6. Equipement de traitement optique selon la revendication 1, **caractérisé en ce que** ledit fluorure représenté par ladite formule générale (2) est tout matériau de LiDyF₄, LiHoF₄, LiErF₄, ou LiYbF₄.
